# EUROPEAN PATENT SPECIFICATION

(11) **EP 2 924 453 B1**
(45) Date of publication and mention of the grant of the patent: **31.10.2018**
(21) Application number: 14161812.4
(22) Date of filing: 26.03.2014
(51) Int. Cl.: G01R 31/34, H02K 15/00, H02K 11/22, G01S 17/08, G01S 7/48

(54) **Method of inspecting a generator air-gap**
Verfahren zur Inspektion eines Generatorluftspalts
Procédé d'inspection d'un entrefer de générateur

(43) Date of publication of application: 30.09.2015
(73) Proprietor: Siemens Aktiengesellschaft, 80333 München (DE)
(72) Inventor: Airoldi, Giovanni, 7100 Vejle (DK); Kordjian, Paul, 7100 Velje (DK); Tourde, Xavier, 7100 Vejle (DK); Urda, Adriana Cristina, 5230 Odense M (DK); Wu, Lijian, 7430 Ikast (DK)

(56) References cited:
- JP-A- H01 299 403
- JP-A- S60 152 250
- US-A1- 2012 119 628

## Description

The invention describes a method of inspecting a generator air-gap, and an air-gap inspection apparatus for detecting an irregularity in the air-gap of a generator.

An electrical motor or generator comprises a rotor and a stator, and the rotor is separated from the stator by an air-gap. The air-gap between rotor and stator plays a very important role in the efficient operation of the machine. Generally, especially in the case of a large electrical machine such as a wind turbine generator, the rotor is realised as the field and bears an arrangement of magnets, while the stator is realised as the armature and bears an arrangement of stator windings.

In the case of a very large electrical machine such as a direct-drive generator, the outer rotor can have a diameter in the range of several metres. Such a generator has a correspondingly high number of stator teeth and magnet poles. For example, in the case of a 3.0 MW direct-drive generator, the inner stator can comprise several stator segments with a total of more than 300 stator teeth, and the rotor housing may have more than 100 slots, while each slot can accommodate several magnet modules or magnet pole pieces. The depth of such a generator, i.e. the distance between a front end and a rear end, can be between 1.0 m and 3.0 m, and the total generator depth may exceed the length of a rotor slot. For safety reasons, the magnet pole pieces are generally inserted into the rotor slots in an automated or semi-automated workflow using suitable machinery.

The air-gap of such a large generator may be only a few millimetres wide and should be as uniform as possible in the spaces between opposing stator teeth and magnet poles. A known visual inspection technique can involve shining a light into the air-gap and looking for any anomaly. However, owing to the depth of the generator, a visual inspection of the air-gap is extremely difficult to carry out and is prone to error. An undetected misalignment of just one magnet pole can have a pronounced negative effect on the air-gap. Similarly, an undetected misalignment of a stator segment may result in an uneven air-gap over a section of the generator. This imbalance can cause uneven torque (torque ripple). Known methods of motor air-gap monitoring are generally designed for use during operation of the motor. For example,
JP H01 299403 A describes an apparatus for directing a light beam at reflectors on either side of the air-gap in order to detect a distortion of the air-gap as the rotor rotates. JP S60 152250 A describes a similar principle, in which a light condensing lens is mounted to the stator, and a photoreceptor is mounted to the rotor so that lens and receptor face each other across the air-gap. Here also, the machine must be operating in order to perform the monitoring. US 2012/119628 A1 considers using a light curtain to detect an anomaly within the air-gap of a machine, and also requires that the machine is operational during the monitoring procedure. However, in the large wind turbine generators described above, any anomaly or irregularity must be detected before the machine is put into operation for the first time, otherwise, in a worst case, an irregularity in the air-gap can lead to a catastrophic collision between rotor and stator when the generator is put into operation. Such a collision is associated with very high costs, particularly in the case of an offshore wind turbine. Therefore, it is of paramount importance to ensure that the air-gap of such a generator is free of any irregularities or anomalies before the generator is installed or put into operation.

It is therefore an object of the invention to provide a reliable and straightforward way of detecting an irregularity in the air-gap of an electrical machine before the electrical machine is installed or put into operation.

This object is achieved by the method of claim 1 of inspecting an air-gap of an electrical machine; and by the air-gap inspection apparatus of claim 9.

According to the invention, the method of inspecting an air-gap of an electrical machine comprises the steps of directing at least one laser beam into the air-gap; detecting the laser beam after reflection; determining the distance travelled by the laser beam; and analysing the travelled distance to detect an irregularity in the air-gap.

The laser beam can be generated by a device such as a laser rangefinder, or a comparable device that operates on the same or similar principle, namely that of directing a laser beam at an object and measuring the time taken for the reflected beam to be detected at the device. The total distance travelled by the laser beam (the sum of the outward and return paths) can then be computed. An advantage of the method according to the invention is that any irregularity in the air-gap, even only a very minor irregularity, can be quickly and easily determined with a very high degree of accuracy. This is a considerable advantage, particularly in the case of a very large electrical machine such as a direct-drive generator with a diameter in the range of several metres and a correspondingly high number of stator teeth and magnet poles, as described in the introduction, since a visual inspection of such a narrow but extensive air-gap is very difficult to carry out and is also prone to error. The method according to the invention provides a way of reliably and accurately detecting any irregularity or anomaly, even in the case of very small deviations or discrepancies in the millimetre range.

According to the invention, the air-gap inspection apparatus for detecting an irregularity in the air-gap of a generator comprises a laser module realised to direct at least one laser beam into the air-gap and to detect the laser beam after reflection; a computation unit realised to determine the distance travelled by the laser beam; and an analysis unit realised to analyse the travelled distance to detect an irregularity in the air-gap.

An advantage of the air-gap inspection apparatus according to the invention is that it can be realised at relatively low cost. Another advantage is that it can carry out a very thorough and precise analysis of the air-gap, so that even very small anomalies or irregularities can be quickly and easily identified.

Particularly advantageous embodiments and features of the invention are given by the dependent claims, as revealed in the following description. Features of different claim categories may be combined as appropriate to give further embodiments not described herein.

In the following, but without restricting the invention in any way, it may be assumed that the electrical machine is a generator such as a direct-drive synchronous generator of the type used in a wind turbine.

In the following, it may be assumed that the air-gap inspection is performed in a post-assembly procedure, i.e. after the generator has been assembled. In a generator such as a direct-drive synchronous generator with outer rotor, the manufacturing steps generally involve assembling the inner stator by mounting stator segments about a cylindrical core, and then inserting the stator into an empty rotor housing. The rotor housing generally comprises an arrangement of parallel slots into which pre-magnetized magnet modules or magnet pole pieces are then inserted, or it may comprise any other suitable magnet holding means. The method of air-gap inspection according to the invention is performed after the rotor housing has been filled with all the necessary number of magnet pole pieces.

In the following, again without restricting the invention in any way, it may be assumed that a laser beam is directed from one end of the generator in the direction of the opposite end. For example, the assembled generator may have an open end (referred to as the drive end) and a closed end (referred to as the non-drive end), whereby the open end might correspond to the front end which will later be connected to the hub of the wind turbine, while the closed end corresponds to a rear end facing into a canopy or nacelle of the wind turbine. This closed end can be closed by a flange that interfaces with a brake disk, or by any other suitable element. The rotor housing itself can extend beyond the length of a rotor slot in order to accommodate any winding overhang. The laser beam can be reflected off the surface of the closed end, back in the direction of the open front end.

A laser beam can be directed into the air-gap according to any suitable scanning pattern, for example a laser beam may be directed diagonally into the air-gap. Preferably, the laser beam is directed into the air-gap in a direction parallel to the axis of rotation of the generator. In this case, the distance travelled by the laser beam can comprise twice the depth of the generator, e.g. twice the depth of the rotor housing, in addition to any offset distance between the laser module and the air-gap and in addition to any offset between the air-gap and the closed end. For any such path taken by the laser beam, a measured distance that exceeds twice the depth of the rotor housing will indicate that the air-gap is free of any irregularity along that path. Preferably, the air-gap inspection apparatus according to the invention is realised to detect an irregularity in the air-gap of a generator with a depth of at least 1.0 m, and which has a correspondingly large diameter in the range of 4.0 m to 7.0 m.

The laser beam might be operated manually, for example by holding a laser rangefinder and directing it into the air-gap. However, unless the operation is performed very exactly, some irregularities may be missed. Therefore, in a preferred embodiment of the invention, the laser beam is controlled to scan area region or volume defined by an outer contour of the stator and an opposing outer contour of the rotor. This approach is based on the insight that, for a particular generator design, a "correct" air-gap will have a certain shape. This shape will be essentially annular, based on the shape of an open-ended cylinder, but with one surface governed by the surface contours of the magnet pole pieces and the rotor housing, and the other surface governed by the surface contours of the stator with its stator teeth and windings. In the following, this annular volume is referred to as the "scan area" or the "area to be scanned". In a preferred embodiment of the invention, the scan area is preferably slightly larger than the actual air-gap so that an anomaly such as rotor ovalization can also be detected. In the method according to the invention, the laser beam can be directed into the scan area towards the rear cover where it is reflected so that it travels back along its return path, and the travelled distance is measured as the laser module moves relative to the scanned area.

The distance travelled by the laser beam can be measured intermittently or at any appropriate interval. Preferably, the laser beam is controlled to follow a predetermined grid pattern in the scanned area, so that the distance travelled by the laser beam is measured at points corresponding to points in such a virtual grid. This approach allows a more precise analysis of any discrepancy, for example to determine the cause of a "too-short" laser path. Here, a "too-short" laser path is determined if the distance travelled by the laser beam on its outward and return journeys through the air-gap is less that twice the length of the air-gap. A group or cluster of such too-short paths can be analysed to determine the cause, for example by considering the shape that would be projected by these too-short paths onto a virtual plane.

The accuracy of such an analysis can depend to some extend on the number of such scan points taken over a certain area, for example the number of scan points per square centimetre of the scan area. In a preferred embodiment of the invention, therefore, a resolution of the grid pattern is determined to enable detection of a misaligned magnet pole and/or to detect an ovalization of the generator rotor and/or to detect a foreign object in the scanned area. The distance travelled by the laser beam is then preferably determined at predetermined scan points of the scanned area according to the grid resolution. For example, the scan area can be virtually divided into a grid of 1.0 mm squares. In this case, the resolution comprises 1.0 mm. Preferably, the resolution or the distance between adjacent scan points comprises at most 1.0 mm, more preferably at most 0.5 mm. A suitably fine resolution can permit the detection of a very small foreign object, for example a small piece of metal such as a burr attracted to a permanent magnet. A fine resolution can also allow the detection of a relatively low degree of ovalization of the rotor housing. Of course, the resolution can be variable, so that a fine resolution is used when scanning a particularly critical region such as the narrowest air-gap sections, as described above, and a coarser resolution can be applied when scanning the wider regions between adjacent rotor slots.

The narrowest point in the air-gap of a generator is generally between a stator tooth and the upper surface of a magnet pole piece. A magnet pole-piece may be essentially flat, but is not necessarily so. A stator tooth generally extends further into the air-gap than a winding arranged between adjacent stator teeth. Therefore, in a further preferred embodiment of the invention, the grid resolution is chosen to comprise at least one, more preferably at least two, most preferably at least three scan points in a most narrow portion of the air-gap. In this way, the air-gap can be analysed very precisely, even if the stator teeth and the magnets are not aligned during the laser inspection procedure.

As indicated above, the laser inspection could be performed manually, for example by holding a laser rangefinder and guiding it in a controlled manner to scan the air-gap as thoroughly as possible. However, in a preferred embodiment of the invention, the air-gap inspection apparatus preferably comprises a mechanical guiding means or actuator realised to guide the laser module over the predetermined scan area. For example, the guiding means can comprise an annular track, and the laser module can be moved along this annular track that corresponds to the annular shape of the generator, while directing the laser beam into the air-gap. Alternatively or in addition, the laser device can be stationary so that it is not displaced relative to the generator, and a guiding means or actuator can be used to tilt the laser device so that the laser beam is swept over a certain angular portion of the air-gap. In each case, since the laser beam travels at the speed of light, measurements can effectively be made instantaneously, so that the laser module can be moved at any suitable rate while taking the measurements.

A single laser module, realised to generate a single laser beam, can be used to inspect the air-gap. Of course, in an alternative preferred embodiment of the invention, the laser module can be realised to direct a plurality of laser beams into the air-gap. For example, the laser module can comprise two (or three, four, etc.) laser rangefinders arranged essentially equidistantly about the guiding means. These can be synchronously controlled so that each laser rangefinder covers one half (or one third, one quarter, etc.) of the scan area. The portions of the scan area covered by the individual laser devices can be separate, or they may overlap to some extent.

As indicated above, the air-gap of a particular generator is associated with a particular shape determined by the number of stator teeth, stator windings and magnet poles. This "expected" or "ideal" area can be determined in advance using the known dimensions of the generator and the stator teeth, windings and magnet poles, and may also take any acceptable tolerances into account, such as rotor eccentricity, magnet thickness tolerances, etc. An allowable or correct air-gap may therefore be regarded as having slightly "fuzzy" contours owing to the acceptable tolerances. The actual air-gap area or shape is computed by collecting laser beam path distances as described above, preferably to a favourably fine resolution. The analysis unit of the air-gap inspection apparatus according to the invention is preferably realised to detect discrepancies between the computed air-gap shape and the expected or ideal air-gap shape. Information or data describing the expected air-gap shape can be stored in a memory module that is accessible to the analysis unit. The analysis unit is preferably realised to be able to map the computed air-gap shape to the expected or allowed air-gap shape in order to be able to determine any discrepancies. To this end, the analysis module preferably also receives information defining the distance of the point of origin of the laser beam relative to the generator's axis of rotation.

The steps of the method are preferably carried out in an automatic or automated manner. To this end, the steps of the method are preferably carried out by a computer program product, when the computer program product is loaded into a memory of a programmable device of an air-gap inspection apparatus according to the invention. For example, various suitable software algorithms can be used to guide the laser device(s) about the scan area; to time the measurements according to a desired resolution or grid; to analyse the measurements in order to obtain an actual picture of the air-gap; and to compare this information with an expected or allowable air-gap to determine the presence of any anomalies or irregularities in the air-gap.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Fig. 1 shows a simplified schematic showing an inspection setup with an embodiment of the air-gap inspection apparatus according to the invention;
Fig. 2 is a simplified rendering of a cross-section through a direct-drive generator;
Fig. 3 shows a first situation in an air-gap inspection procedure using the method according to the invention;
Fig. 4 shows a second situation in the air-gap inspection procedure of Fig. 3;
Fig. 5 shows a grid pattern overlaid on an air-gap of a generator;
Fig. 6 shows potential irregularities in the air-gap of Fig. 5, as detected by the apparatus according to the invention.

In the diagrams, like numbers refer to like objects throughout. Objects in the diagrams are not necessarily drawn to scale.

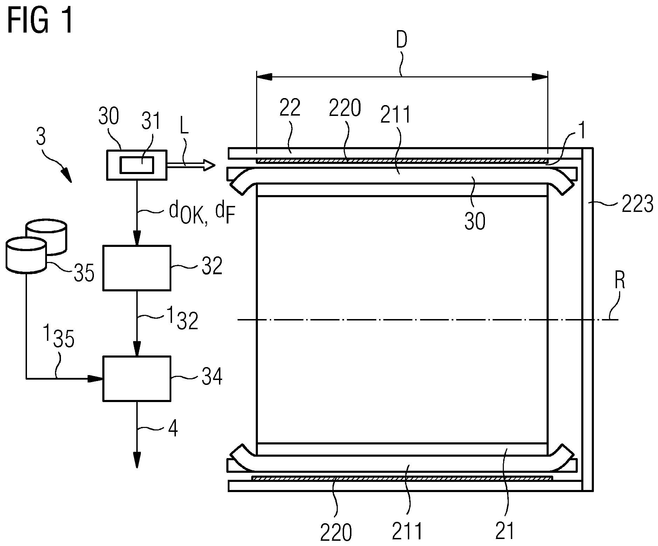

Fig. 1 is a simplified schematic showing an inspection setup comprising an embodiment of the air-gap inspection apparatus 3 according to the invention and a generator 2 undergoing inspection. For the sake of clarity the diagram only shows a simplified cross-section through the generator 2 and only shows relevant components such as the rotor 22, magnet poles 220, the stator 21, stator windings 211, and a rear cover 223 of the rotor housing. The length of the air-gap 1 corresponds essentially to the length D of a rotor slot holding a number of magnet poles 220. The stator 21 and rotor 22 are arranged about the axis of rotation R of the generator. The air-gap inspection apparatus 3 comprises a laser module 30, a computation unit 31, an analysis unit 32, and a processing unit 34 such as a microprocessor, as well as a memory module 35. The memory module 35 is used to store data describing a number of features of an ideal or expected air-gap shape, as will be explained below. During inspection, the laser module 30 generates a laser beam L, which is directed along the air-gap 1 towards the rear covering 223 of the rotor housing. The path travelled by the laser beam L on its outward and return journeys can therefore be at most twice the distance d_{OK} between the laser module 30 and the rear cover 223, whereby the laser beam L can travel in a path parallel to the axis of rotation R, or can be directed at an angle to the axis of rotation R. If there is an irregularity in the air-gap, the path of the laser beam L is interrupted and reflected back to the laser module 30, so that it travels a shorter distance d_{F}. The laser module 30 can be guided to direct the laser beam L over the entire air-gap 1, covering as much of the air-gap 1 as practicable. This is achieved by using an appropriate guiding means or actuator (not shown) to control the motion of the laser module 30. The laser beam L is directed over a pre-defined grid pattern so that measurements can be taken at specific scan points, as will be explained below. The distances d_{OK}, d_{F} measured are provided by the computation unit 31, which in this case is realised as part of the laser module 30. This can be a known type of laser rangefinder, for example. Information from the computation unit 31 is forwarded to an analysis unit 32, which can use the measured distances to make a 'picture' of the actual air-gap shape 1₃₂. This is then compared to an expected air-gap shape 1₃₅ stored in the memory 35. If the actual and expected air-gap shapes 1₃₂, 1₃₅ match up, it may be assumed that the air-gap 1 is 'clean' and free of any irregularities. However, a mismatch between the air-gap shapes 1₃₂, 1₃₅ can indicate that the air-gap 1 is not satisfactory. A comparison between the air-gap shapes 1₃₂, 1₃₅ can be performed by the processor 34, which may also be able to determine the reason for the mismatch. For example, a comparison between the air-gap shapes 1₃₂, 1₃₅ may indicate that a specific magnet pole piece is misaligned so that one side of it protrudes too far into the air-gap. An appropriate output signal 4 may inform a technician of the nature of the irregularity.

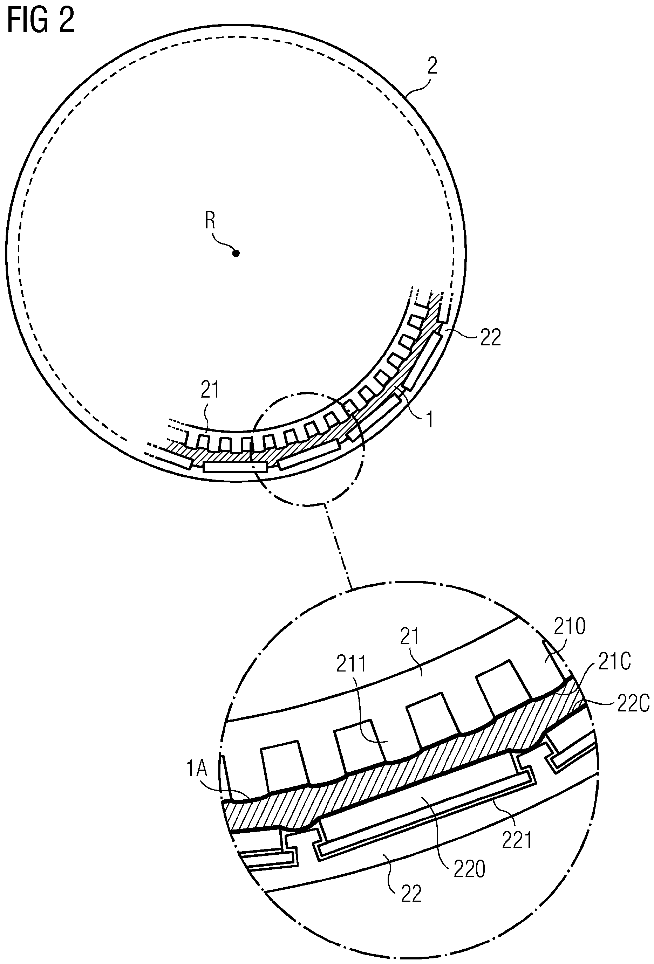

Fig. 2 is a simplified rendering of a cross-section through a direct-drive generator 2. The diagram shows an outer rotor 22 and an inner stator 21. The stator 21 comprises several sections each with a number of stator windings 210 separated by stator teeth 211. The rotor 22 comprises a housing with rotor slots 221, and each rotor slot 221 can accommodate a number of magnet pole pieces 220. The contours 21C, 22C of the stator 21 and rotor 22, respectively, are shown in greater detail in the enlarged portion of the diagram. The air-gap 1 between rotor 22 and stator 21 is also shown. This is at its narrowest when a stator tooth 211 passes over a magnet pole piece 220. In a stationary position of the generator 2, for example during the laser inspection method according to the invention, the shape of the air-gap 1 is well-defined, since the geometries of the stator 21 and rotor 22 are known, as are any relevant tolerances of the generator 2. Therefore, for a particular position of the stator 21 relative to the rotor 22, the ideal or expected shape 1A of the air-gap 1 can be determined in a relatively straightforward manner. The enlarged part of the diagram indicates a portion of this expected air-gap shape 1A indicated by hatching. The completed air-gap shape 1A will be essentially annular. The annular shape 1A should be the same for a cross-section taken at any depth in the generator 2, assuming that the rotor slots 221 run parallel to the axis of rotation R, since the air-gap is a volume with a shape corresponding essentially to an open-ended cylinder. For a generator with skewed rotor slots or staggered magnet pole pieces, the air-gap cross-sectional shape will progressively change with increasing depth through the generator. Again, this geometrical or topological information is known and can be easily taken into consideration when determining an acceptable or expected air-gap shape.

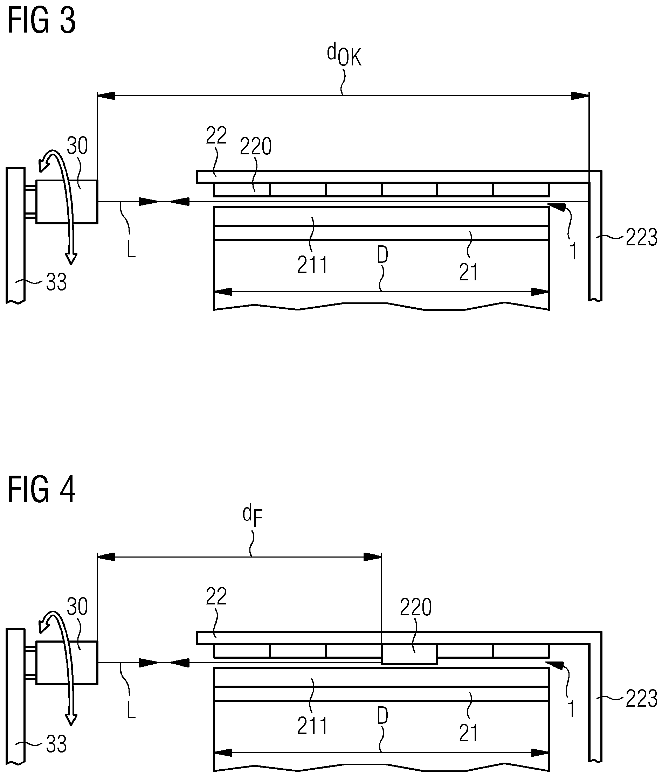

Fig. 3 shows a first situation in an air-gap inspection procedure using the method according to the invention. The diagram shows a simplified cross-section through the generator and only shows relevant components such as the rotor 22, a row of six magnet pole pieces 220 in a rotor slot, the stator 21, a stator winding 211, and a rear cover 223 of the rotor housing. The length of the air-gap 1 corresponds essentially to the length D of a rotor slot or the length of the six pole pieces 220. Here, a laser beam L originating from a laser module 30 is being directed through the air-gap 1, in a direction essentially parallel to the axis of rotation of the generator. Ideally, the laser beam L will pass without interruption through the air-gap 1 to the rear cover 223 of the rotor housing, and will return to the laser module 30, which can then determine the length of the path travelled. In the absence of any irregularities in the air-gap 1, the laser beam L travels a distance that is twice the distance d_{OK} between the laser module 30 and the rear cover 223. This can be computed by the computation unit and stored for later use by the analysis unit, as described above. A guiding means 33 is used to guide the laser module 30 along an annular path as indicated by the arrow. The guiding means 33 can also effect a radial displacement of the laser module 30 (relative to the axis of rotation of the generator) so that the laser beam L can be directed over the desired grid pattern as the length of the laser beam is repeatedly measured.

Fig. 4 shows a second situation in the air-gap inspection procedure of Fig. 3. Here, the laser beam L cannot reach the rear cover 223 for reflection, since a misaligned pole piece 220 (the fourth pole piece from the front opening of the generator) is protruding into the air-gap 1. Therefore, the length of the path travelled in this case is only twice the distance d_{F} between the laser module 30 and the misaligned pole piece 220, indicating the presence of a fault. Here also, this information is computed by the computation unit and stored for later use by the analysis unit, as described above.

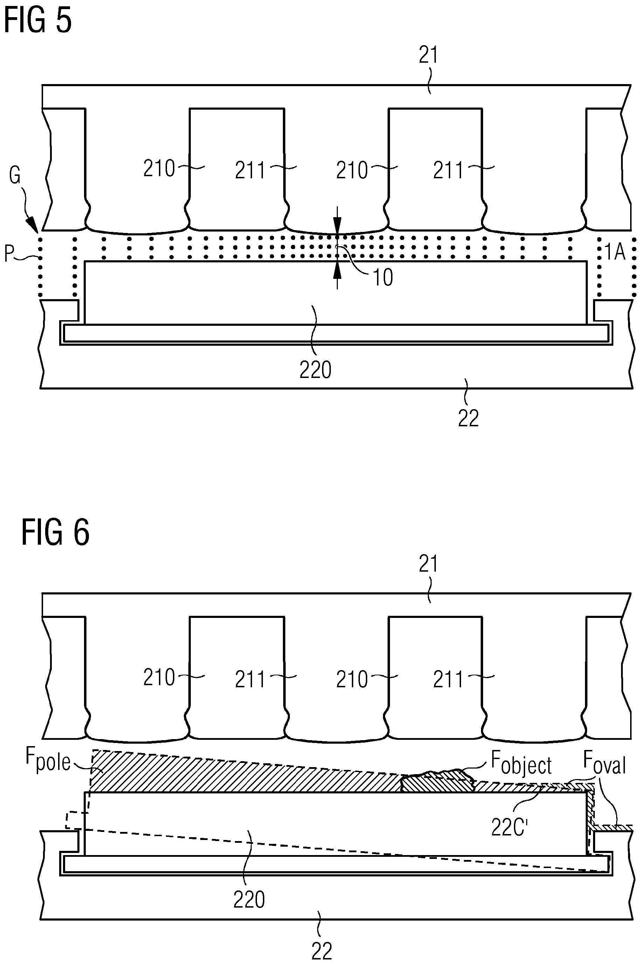

Fig. 5 shows a grid pattern G overlaid on the scan area 1A of the air-gap 1 of a generator. The diagram indicates an exemplary pattern of scan points P, corresponding to instances at which a laser measurement is taken. For example, the laser can be guided to travel alternately up and down as it traverses the grid pattern from left to right. At the widest part of the air-gap, as shown for example in the lefthand side of this diagram, five measurements may be taken during an upward or downward motion of the laser. Towards the centre of the diagram, the laser is guided to scan the narrowest portion 10 of the air-gap 1, and up to three measurements are taken during an upward or downward motion of the laser. To improve the accuracy of the inspection the laser can be guided such that the distance between upward and downward paths is less, i.e. the grid pattern G is denser about the narrower portion 10 of the air-gap 1.

Fig. 6 shows potential irregularities Fₚₒₗₑ, Fₒᵥₐₗ, F_{object} in the air-gap 1 of Fig. 5, as detected by the apparatus according to the invention. By comparing the computed air-gap shape to the expected or allowable air-gap shape, any discrepancy detected, even allowing for the known tolerances, can be assumed to be an irregularity that must be dealt with before activating the generator. For example, an irregularity Fₚₒₗₑ owing to a misaligned pole piece must be dealt with by removing the misaligned pole piece and re-inserting it correctly. An irregularity F_{object} indicating the presence of an object in the air-gap can be dealt with by drawing the object out of the space between stator and rotor, for example manually or by vacuum extraction. An irregularity Fₒᵥₐₗ, indicated by the broken line showing a displaced rotor contour can arise owing to an ovalization of the rotor 22. This can be corrected, for example by later securing an anti-ovalization ring to the rotor front face.

Although the present invention has been disclosed in the form of preferred embodiments and variations thereon, it will be understood that numerous additional modifications and variations could be made thereto without departing from the scope of the invention.

For the sake of clarity, it is to be understood that the use of "a" or "an" throughout this application does not exclude a plurality, and "comprising" does not exclude other steps or elements. The mention of a "unit" or a "module" does not preclude the use of more than one unit or module.

## Claims

1. A method of inspecting an air-gap (1) of an electrical machine (2), which method comprises the steps of
- directing at least one laser beam (L) into the air-gap (1); **characterised by**
- detecting the laser beam (L) after reflection;
- determining the distance (d_{OK}, d_{F}) travelled by the laser beam (L); and
- analysing the travelled distance (d_{OK}, d_{F}) to detect an irregularity (Fₚₒₗₑ, Fₒᵥₐₗ, F_{object}) in the air-gap (1).

2. A method according to claim 1, wherein the laser beam (L) is directed into the air-gap (1) in a direction essentially parallel to a rotational axis (R) of the electrical machine (2) .

3. A method according to claim 1 or claim 2, wherein the laser beam (L) is controlled to scan an area (1A) defined by an outer contour (21C) of the stator (21) and an opposing outer contour (22C) of the rotor (22) of the electrical machine (2).

4. A method according to claim 3, wherein the laser beam (L) is controlled to follow a predetermined grid pattern (G) in the scanned area (1A).

5. A method according to claim 4, wherein a resolution of the grid pattern (G) is determined to enable detection of a magnet pole misalignment (Fₚₒₗₑ) and/or to detect an ovalization (Fₒᵥₐₗ) of the rotor (22) and/or to detect a foreign object (F_{object}) in the scanned area (1A).

6. A method according to any of claims 3 to 5, wherein the distance (d_{OK}, d_{F}) travelled by the laser beam (L) is determined at predetermined scan points (P) of the scanned area (1A) according to the grid resolution.

7. A method according to claim 5 or claim 6, wherein the grid resolution comprises at least one scan point (P) in a most narrow portion of the air-gap (1)

8. A method according to claim 6 or claim 7, wherein the distance between adjacent scan points (P) comprises at most 1.0 mm, more preferably at most 0.5 mm.

9. An air-gap inspection apparatus (3) for detecting an irregularity in the air-gap (1) of an electrical machine (2), which apparatus (3) comprises
- a laser module (30) realised to direct at least one laser beam (L) into the air-gap (1) **characterised in that** the laser module is realised to detect the laser beam (L) after reflection;
- a computation unit (31) realised to determine the distance (d_{OK}, d_{F}) travelled by the laser beam (L); and
- an analysis unit (32) realised to analyse the travelled distance (d_{OK}, d_{F}) to detect an irregularity in the air-gap (1).

10. An air-gap inspection apparatus according to claim 9, comprising a guiding means (33) realised to guide the laser module (30) to scan an area (1A) defined by opposing contours (21C, 22C) of the stator (21) and the rotor (22) of the electrical machine (2).

11. An air-gap inspection apparatus according to claim 9 or claim 10, wherein the laser module (30) is realised to direct a plurality of laser beams (L) into the air-gap (1).

12. An air-gap inspection apparatus according to claim 11, wherein each of the plurality of lasers (L) is controlled to cover a separate portion of the area (1A) to be scanned.

13. An air-gap inspection apparatus according to any of claims 9 to 12, wherein the analysis unit (32) is realised to detect a discrepancy between a computed cross-sectional air-gap area and an ideal air-gap area.

14. An air-gap inspection apparatus according to any of claims 9 to 13, realised to detect an irregularity (Fₚₒₗₑ, Fₒᵥₐₗ, F_{object}) in the air-gap (1) of an electrical machine (2) with a depth (D) of at least 1.0 m.

15. A computer program product for carrying out the steps of the method according to any of claims 1 to 8, when the computer program product is loaded into a memory of a programmable device (34) of an air-gap inspection apparatus (3) according to any of claims 9 to 14.

## Patentansprüche

1. Verfahren zum Überprüfen eines Luftspalts (1) bei einer elektrischen Maschine (2), das folgendes Schritte umfasst:
- Richten mindestens eines Laserstrahls (L) in den Luftspalt (1), **gekennzeichnet durch**
- das Erkennen des Laserstrahls (L) nach der Reflexion,
- das Ermitteln der von dem Laserstrahl (L) zurückgelegten Strecke (d_{OK}, d_{F}) und
- das Analysieren der zurückgelegten Strecke (d_{OK}, d_{F}) zum Erkennen einer Unregelmäßigkeit (Fₚₒₗₑ, Fₒᵥₐₗ, F_{object}) des Luftspalts (1).

2. Verfahren nach Anspruch 1, wobei der Laserstrahl (L) in einer Richtung in den Luftspalt (1) gerichtet wird, die im Wesentlichen parallel zu einer Rotationsachse (R) der elektrischen Maschine (2) verläuft.

3. Verfahren nach Anspruch 1 oder 2, wobei der Laserstrahl (L) so gesteuert wird, dass er einen Bereich (1A) abtastet, der durch ein Außenprofil (21C) des Stators (21) und ein gegenüberliegendes Außenprofil (22C) des Rotors (22) der elektrischen Maschine (2) definiert ist.

4. Verfahren nach Anspruch 3, wobei der Laserstrahl (L) so gesteuert wird, dass er einem vorgegebenen Rastermuster (G) in dem abgetasteten Bereich (1A) folgt.

5. Verfahren nach Anspruch 4, wobei eine Auflösung des Rastermusters (G) so festgelegt ist, dass sie ein Erkennen eines Magnetpolversatzes (Fₚₒₗₑ) ermöglicht und/oder eine Ovalisierung (Fₒᵥₐₗ) des Rotors (22) und/oder einen Fremdkörper (F_{object}) in dem abgetasteten Bereich (1A) erkennt.

6. Verfahren nach einem der Ansprüche 3 bis 5, wobei die von dem Laserstrahl (L) zurückgelegte Strecke (d_{OK}, d_{F}) an vorgegebenen Abtastpunkten (P) des abgetasteten Bereichs (1A) der Rasterauflösung entsprechend ermittelt wird.

7. Verfahren nach Anspruch 5 oder 6, wobei die Rasterauflösung mindestens einen Abtastpunkt (P) in einem schmalsten Abschnitt des Luftspalts (1) umfasst.

8. Verfahren nach Anspruch 6 oder 7, wobei die Strecke zwischen benachbarten Abtastpunkten (P) maximal 1,0 mm, bevorzugt maximal 0,5 mm, beträgt.

9. Luftspaltüberprüfungsvorrichtung (3) zum Erkennen einer Unregelmäßigkeit des Luftspalts (1) bei einer elektrischen Maschine (2), wobei die Vorrichtung (3) Folgendes umfasst:
- ein Lasermodul (30), das so ausgelegt ist, dass es mindestens einen Laserstrahl (L) in den Luftspalt (1) richtet, **dadurch gekennzeichnet, dass** das Lasermodul so ausgelegt ist, dass es den Laserstrahl (L) nach der Reflexion erkennt,
- eine Recheneinheit (31), die so ausgelegt ist, dass sie die von dem Laserstrahl (L) zurückgelegte Strecke (d_{0K}, d_{F}) ermittelt, und
- eine Analyseeinheit (32), die so ausgelegt ist, dass sie die zurückgelegte Strecke (d_{0K}, d_{F}) analysiert, damit eine Unregelmäßigkeit des Luftspalts (1) erkannt wird.

10. Luftspaltüberprüfungsvorrichtung nach Anspruch 9, die ein Führungsmittel (33) umfasst, das so ausgelegt ist, dass es das Lasermodul (30) zum Abtasten eines Bereichs (1A) führt, der durch sich gegenüberliegende Profile (21C, 22C) des Stators (21) und des Rotors (22) der elektrischen Maschine (2) definiert ist.

11. Luftspaltüberprüfungsvorrichtung nach Anspruch 9 oder 10, wobei das Lasermodul (30) so ausgelegt ist, dass es mehrere Laserstrahlen (L) in den Luftspalt (1) richtet.

12. Luftspaltüberprüfungsvorrichtung nach Anspruch 11, wobei jeder der mehreren Laser (L) so gesteuert ist, dass er einen separaten Abschnitt des abzutastenden Bereichs (1A) überstreicht.

13. Luftspaltüberprüfungsvorrichtung nach einem der Ansprüche 9 bis 12, wobei die Analyseeinheit (32) so ausgelegt ist, dass sie eine Abweichung zwischen einer berechneten Luftspaltquerschnittsfläche und einer idealen Luftspaltfläche erkennt.

14. Luftspaltüberprüfungsvorrichtung nach einem der Ansprüche 9 bis 13, die so ausgelegt ist, dass sie eine Unregelmäßigkeit (Fₚₒₗₑ, Fₒᵥₐₗ, F_{object}) des Luftspalts (1) bei einer elektrischen Maschine (2) mit einer Tiefe (D) von mindestens 1,0 m erkennt.

15. Computerprogrammprodukt zum Ausführen der Schritte des Verfahren nach einem der Ansprüche 1 bis 8, wenn das Computerprogrammprodukt in einen Speicher einer programmierbaren Vorrichtung (34) einer Luftspaltüberprüfungsvorrichtung (3) nach einem der Ansprüche 9 bis 14 geladen ist.

## Revendications

1. Procédé d'inspection d'un entrefer (1) d'une machine électrique (2), lequel procédé comprend les étapes consistant à
- diriger au moins un faisceau laser (L) dans l'entrefer (1) ; **caractérisé par**
- la détection du faisceau laser (L) après une réflexion ;
- la détermination de la distance (d_{OK}, d_{F}) parcourue par le faisceau laser (L) ; et
- l'analyse de la distance parcourue (d_{OK}, d_{F}) pour détecter une irrégularité (Fₚₒₗₑ, Fₒᵥₐₗ, F_{object}) dans l'entrefer (1).

2. Procédé selon la revendication 1, dans lequel le faisceau laser (L) est dirigé dans l'entrefer (1) dans une direction essentiellement parallèle à un axe de rotation (R) de la machine électrique (2).

3. Procédé selon la revendication 1 ou la revendication 2, dans lequel le faisceau laser (L) est commandé pour balayer une zone (1A) définie par un contour externe (21C) du stator (21) et un contour externe opposé (22C) du rotor (22) de la machine électrique (2).

4. Procédé selon la revendication 3, dans lequel le faisceau laser (L) est commandé pour suivre un motif de grille prédéterminé (G) dans la zone balayée (1A).

5. Procédé selon la revendication 4, dans lequel une résolution du motif de grille (G) est déterminée pour permettre la détection d'un désalignement de pôles magnétiques (Fₚₒₗₑ) et/ou pour détecter une ovalisation (Fₒᵥₐₗ) du rotor (22) et/ou pour détecter un objet étranger (F_{object}) dans la zone balayée (1A).

6. Procédé selon l'une quelconque des revendications 3 à 5, dans lequel la distance (d_{OK}, d_{F}) parcourue par le faisceau laser (L) est déterminée au niveau de points de balayage prédéterminés (P) de la zone balayée (1A) selon la résolution de grille.

7. Procédé selon la revendication 5 ou la revendication 6, dans lequel la résolution de grille comprend au moins un point de balayage (P) dans une portion la plus étroite de l'entrefer (1) .

8. Procédé selon la revendication 6 ou la revendication 7, dans lequel la distance entre des points de balayage adjacents (P) comprend tout au plus 1,0 mm, plus préférablement tout au plus 0,5 mm.

9. Appareil d'inspection d'entrefer (3) destiné à détecter une irrégularité dans l'entrefer (1) d'une machine électrique (2), lequel appareil (3) comprend
- un module laser (30) réalisé pour diriger au moins un faisceau laser (L) dans l'entrefer (1) **caractérisé en ce que** le module laser est réalisé pour détecter le faisceau laser (L) après une réflexion ;
- une unité de calcul (31) réalisée pour déterminer la distance (d_{OK}, d_{F}) parcourue par le faisceau laser (L) ; et
- une unité d'analyse (32) réalisée pour analyser la distance parcourue (d_{OK}, d_{F}) pour détecter une irrégularité dans l'entrefer (1).

10. Appareil d'inspection d'entrefer selon la revendication 9, comprenant un moyen de guidage (33) réalisé pour guider le module laser (30) pour balayer une zone (1A) définie par des contours opposés (21C, 22C) du stator (21) et le rotor (22) de la machine électrique (2).

11. Appareil d'inspection d'entrefer selon la revendication 9 ou la revendication 10, dans lequel le module laser (30) est réalisé pour diriger une pluralité de faisceaux laser (L) dans l'entrefer (1).

12. Appareil d'inspection d'entrefer selon la revendication 11, dans lequel chacun de la pluralité de lasers (L) est commandé pour couvrir une portion distincte de la zone (1A) à balayer.

13. Appareil d'inspection d'entrefer selon l'une quelconque des revendications 9 à 12, dans lequel l'unité d'analyse (32) est réalisée pour détecter une divergence entre une zone d'entrefer en coupe transversale calculée et une zone d'entrefer idéale.

14. Appareil d'inspection d'entrefer selon l'une quelconque des revendications 9 à 13, réalisé pour détecter une irrégularité (Fₚₒₗₑ, Fₒᵥₐₗ, F_{object}) dans l'entrefer (1) d'une machine électrique (2) avec une profondeur (D) d'au moins 1,0 m.

15. Produit de programme informatique destiné à mettre en oeuvre les étapes du procédé selon l'une quelconque des revendications 1 à 8, lorsque le produit de programme informatique est chargé dans une mémoire d'un dispositif programmable (34) d'un appareil d'inspection d'entrefer (3) selon l'une quelconque des revendications 9 à 14.
